(19) Europäisches Patentamt
European Patent Office
Office européen des brevets

(11) **EP 2 465 142 B1**

(12) **EUROPÄISCHE PATENTSCHRIFT**

(45) Veröffentlichungstag und Bekanntmachung des Hinweises auf die Patenterteilung:
**11.11.2015 Patentblatt 2015/46**

(21) Anmeldenummer: **10751977.9**

(22) Anmeldetag: **14.09.2010**

(51) Int Cl.:
***H01L 29/778*** (2006.01)

(86) Internationale Anmeldenummer:
**PCT/EP2010/063496**

(87) Internationale Veröffentlichungsnummer:
**WO 2011/032949 (24.03.2011 Gazette 2011/12)**

(54) **HALBLEITERSTRUKTUR**

SEMICONDUCTOR STRUCTURE

STRUCTURE SEMI-CONDUCTRICE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **15.09.2009 DE 102009041548**

(43) Veröffentlichungstag der Anmeldung:
**20.06.2012 Patentblatt 2012/25**

(73) Patentinhaber: **Fraunhofer-Gesellschaft zur Förderung der angewandten Forschung e.V.
80686 München (DE)**

(72) Erfinder:
• **LIM, Taek
79312 Emmendingen (DE)**
• **AIDAM, Rolf
79369 Wyhl (DE)**
• **KIRSTE, Lutz
79110 Freiburg (DE)**
• **QUAY, Rüdiger
79102 Freiburg (DE)**

(74) Vertreter: **Hersina, Günter et al
Schoppe, Zimmermann, Stöckeler
Zinkler, Schenk & Partner mbB
Patentanwälte
Radlkoferstrasse 2
81373 München (DE)**

(56) Entgegenhaltungen:
**WO-A1-2008/148101 JP-A- 2003 257 999**

• **TAEK LIM ET AL: "Design of near lattice-matched AlGaInN-barriers for highly-scalable GaN-based transistor structures" PHYSICA STATUS SOLIDI C, Bd. 7, Nr. 7-8, 28. April 2010 (2010-04-28), Seiten 1958-1960, XP002610644 WILEY-VCH VERLAG GMBH GERMANY ISSN: 1862-6351 DOI: 10.1002/PSSC.200983530**
• **LIM T ET AL: "Compositional variation of nearly lattice-matched InAlGaN alloys for high electron mobility transistors" APPLIED PHYSICS LETTERS AMERICAN INSTITUTE OF PHYSICS, Bd. 96, Nr. 25, 25. Juni 2010 (2010-06-25), Seiten 252108-1-252108-3, XP002610645 USA ISSN: 0003-6951 DOI: 10.1063/1.3456561**

**Beschreibung**

Ausführungsbeispiele gemäß der Erfindung beziehen sich auf Heterostruktur-Halbleiterbauelemente und insbesondere auf eine Halbleiterstruktur, einen Transistor und ein Verfahren zur Herstellung einer Halbleiterstruktur.

Bei dem Heterostruktur-Feldeffekttransistor wird der durch das Bauelement zwischen den beiden Ohmschen Kontakten Source und Drain fließende Strom mittels einer an einem sperrenden Metall-Halbleiter-Kontakt (Gate) angelegten Spannung idealerweise leistungslos gesteuert. Im Unterschied zu homogenen Feldeffekttransistoren liegt bei einem HFET ein heterogenes Materialsystem vor. Dabei wird ausgenutzt, dass sich bei der Kombination zweier geeigneter Halbleitermaterialien mit unterschiedlichen Bandlückenenergien an deren Grenzfläche ein Potenzialtopf mit diskreten Energieniveaus ausbildet, welcher den Kanal darstellt. Der Vorteil liegt in der Trennung von Ladungsträgern und dem dotierten Bereich. Dadurch, dass der Stromtransport im undotierten Material stattfindet, lassen sich hohe Beweglichkeiten und damit gute Hochfrequenzeigenschaften erzielen. Durch die angelegte Gate-Spannung wird die Ladungsträgerkonzentration im Kanal moduliert.

Heterostruktur-Feldeffekttransistoren (HFETs, Hetero Structure Field Effect Transistors), auch als Transistor mit hoher Elektronenbeweglichkeit (HEMTs, High Electron Mobility Transistors) bezeichnet, die auf Nitriden der Gruppe III beruhen, sind in der Lage, höhere Leistungen bei hohen Frequenzen von üblicherweise 1-100 GHz zu handhaben als vergleichbare Vorrichtungen, die auf anderen Halbleitermaterialsystemen beruhen. Diese Fähigkeiten sind eine Folge der einzigartigen Materialeigenschaften von III-Nitriden, die einen breiten Bandabstand, ein großes Durchbruchsfeld und eine hohe Ladungsträgersättigungsgeschwindigkeit aufweisen. Durch Verwendung der binären Verbindungen Aluminiumnitrid (AlN), Galliumnitrid (GaN), Indiumnitrid (InN) und ihrer Legierungen (ternäres AlGaN, GaInN, AlInN sowie quaternäres AlGaInN) kann eine große Bandbreite an gewünschten Materialeigenschaften abgedeckt werden. Etablierte Anwendungen decken hauptsächlich den Bereich zwischen 2 und 12 GHz ab. Bei höheren Frequenzen, beispielsweise um 35 GHz und 94 GHz für Radar mit einer hohen räumlichen Auflösung, können Nitrid-HFETs Leistungspegel bieten, die bisher für Festkörpersysteme nicht zugänglich sind. Diese Anwendungen erfordern eine kleine Gate-Länge und somit dünne Barrierenschichten in Kombination mit hohen Flächenladungsträgerdichten und hohen Elektronenbeweglichkeiten.

Die für eine Anwendung bei HFETs am besten erforschte Heterostruktur ist das AlGaN/GaN-System. Obwohl das Materialwachstum und die Bauelementtechnologie für AlGaN/GaN einen ziemlich hohen Reifegrad erreicht haben, ist die Spannung in der AlGaN-Schicht ein inhärenter Nachteil, der zu physikalischen Grenzen für den Bauelemententwurf führt. Dieses Problem wirkt besonders schwerwiegend bei der Verwirklichung von Heterostrukturen mit einer Flächenelektronendichte von mehr als $1,5 \times 10^{13}$ cm$^{-2}$, was aufgrund von Spannungsrelaxation und Begrenzung der Lebensdauer mit AlGaN/GaN fast nicht möglich ist. Ein weiterer damit verbundener Nachteil von AlGaN/GaN ist die Schwierigkeit, Heterostrukturen mit gleichzeitig hoher Flächenelektronendichte und einer dünnen Barriere herzustellen, wie es für eine effektive Skalierung mit der Gate-Länge für schnelle Transistoren erforderlich ist.

In neueren Berichten wurde die AlGaN-Barriere durch die Verbindung AlInN bei einer Indiumkonzentration von etwa 18 % ersetzt (siehe z.B. "Gonschorek et al., Appl. Phys. Lett. 89, 062106 (2006)" und "Xie et al., Appl. Phys. Lett. 91, 132116 (2007)"). Bei dieser Zusammensetzung ist die in-Ebene vorliegende Gitterkonstante von AlInN dieselbe wie von GaN, so dass eine AlInN/GaN-Heterostruktur gitterangepasst und frei von Spannungen ist. Aufgrund des hohen Aluminiumgehalts und folglich einer hohen spontanen Polarisation von gitterangepasstem AlInN ist eine Barriereschichtdicke von weniger als 10 nm ausreichend, um eine hohe Flächenelektronendichte zu erhalten. Jedoch weist AlInN eine Legierungs-Nichtmischbarkeit und folglich eine schlechte Materialqualität auf. Einfache AlInN/GaN-Heterostrukturen weisen lediglich einen Bruchteil der Elektronenbeweglichkeit von typischen AlGaN/GaN-Wafern auf. Außerdem weisen Ohmsche Kontakte mit AlInN-basierten Strukturen, die für einen HFET-Betrieb wesentlich sind, Anschlusswiderstände auf, die um mehrere Faktoren höher sind als bei AlGaN-basierten Referenzen.

Die Elektronenbeweglichkeit bei AlInN-basierten Heterostrukturen kann stark verbessert werden, indem eine AlN-Zwischenschicht zwischen den GaN-Kanal und die gitterangepasste Barriereschicht eingefügt wird ("Gonschorek et al., Appl. Phys. Lett. 89, 062106 (2006)"). Das AlN dient als Abstandshalter, der das zweidimensionale Elektronengas (2DEG) in den Kanal von der AlInN-Barriereschicht trennt und im Vergleich zu einer direkten AlInN/GaN-Sequenz eine verbesserte Grenzflächenrauhigkeit ermöglicht. Trotzdem erreichen sogar optimierte AlInN/AlN/GaN-Strukturen nur Beweglichkeitswerte, die beträchtlich unter denen von AlGaN/GaN- oder AlGaN/AlN/GaN-Strukturen liegen.

Weitere Beispiele von Heterostrukturen und deren Anwendungen sind im Folgenden aufgeführt. So zeigt beispielsweise die Patentschrift US 2002/058349 A1 ein Verfahren zur Herstellung von Nitrid-basierten Heterostruktur-Bauelementen durch die Verwendung von quaternären Schichten, die AlInNGaN aufweisen.

Des Weiteren beschreibt die Patentschrift US 2008/0054303 A1 einen III-Nitrid-basierten Feldeffekttransistor, der eine verbesserte Leistungscharakteristik durch eine Manipulation der Beziehung zwischen den in-Ebene Gitterkonstanten der Schnittstelle von Materialschichten erhält.

Zusätzlich zeigt die Patentschrift US 2006/0197109 A1 einen Transistor mit hoher Elektronenbeweglichkeit mit einer GaN-Kanalstruktur mit einer sehr dünnen (Al, In, Ga)N-Subkanalschicht, die zwischen einer ersten GaN-Kanalschicht und einer zweiten GaN-Kanalschicht angeordnet ist, um eine Bandverbiegung induziert durch die piezoelektrische und spontane Ladungsträger in Assoziation mit der (Al, In, Ga)N-Subkanalschicht verursacht. Es werden dadurch zwei oder mehr Kanäle ausgebildet, um die Linearität des Transistors zu verbessern.

Die Druckschrift "Liu et al., Appl. Phy. Lett. 86, 223510 (2005) Demonstration of undoped quaternary AlInGaN/GaN hertostructure field-effect transistor on sapphire substrate" demonstriert einen undotierten AlInGaN- Heterostruktur-Feldeffekttransistor auf einem Saphirsubstrat.

Des Weiteren zeigt die Druckschrift "Liu et al., Jpn. J. Appl. Phys. 45, 5728-5731 (2006) Novel quaternary AlInGaN/GaN heterostructure field effect transistors on sapphire sub-strate" einen undotierten quaternären AlInGaN/GaN- Heterostruktur-Feldeffekttransistor mit unterschiedlichen Aluminiummolanteilen, der auf Saphirsubstrat hergestellt ist.

Zusätzlich wird in "Adivarahan et al., IEEE Trans. Electron Devices 55, 495-499 (2008) Double-recessed high-frequency AlInGaN/GaN metal-oxide double heterostructure field-effect transistors" ein niederschwelliger AlInGaN/InGaN/GaN-Metall-Oxid-Halbleiterdoppelheterostruktur-Feldeffekttransistor für Hochfrequenzanwendungen beschrieben.

Die JP 2003-257999 A bezieht sich auf einen Feldeffekttransistor mit Heteroübergang unter Verwendung eines Nitridhalbleitermaterials. Bei der Struktur des Feldeffekttransistors unter Verwendung des Nitridhalbleitermaterials ist der Teil einer Barriere, der mit einem Kanal, der in der Nähe des Heteroübergangs einer Gallium-Nitrid-Schicht gebildet wird, und mit der Barriere in Kontakt gebracht wird, als eine Mehrschichtstruktur ausgebildet, die abwechselnd eine Aluminium-Nitrid-Schicht mit einer Dicke von weniger als 2 nm und eine Gallium-Nitrid-Schicht mit einer Dicke von weniger als 2 nm aufweist.

Die Aufgabe der vorliegenden Erfindung ist es, eine verbesserte Halbleiterstruktur für Heterostrukturbauelemente zu schaffen, die es ermöglicht, die Ladungsträgerbeweglichkeit in einer Kanalschicht und/oder die Lebensdauer der Heterostrukturbauelementen zu erhöhen.

Diese Aufgabe wird durch eine Halbleiterstruktur gemäß Anspruch 1 oder 10 oder einem Verfahren gemäß Anspruch 11 gelöst.

Ein Ausführungsbeispiel gemäß der Erfindung schafft eine Halbleiterstruktur, die eine Barriereschicht, eine Abstandshalterstruktur und eine Kanalschicht umfasst. Die Barriereschicht weist ein Gruppe-III-Nitrid auf. Des Weiteren umfasst die Abstandshalterstruktur eine erste Aluminiumnitridschicht, eine zweite Aluminiumnitridschicht und eine Zwischenschicht. Die Zwischenschicht weist ein Gruppe-III-Nitrid auf und ist zwischen der ersten Aluminiumnitridschicht und der zweiten Aluminiumnitridschicht angeordnet. Die Zwischenschicht weist an einer Grenzfläche zu der zweiten Aluminiumnitridschicht eine erste freie Ladungsträgerdichte auf. Die Abstandshalterstruktur ist zwischen der Barriereschicht und der Kanalschicht angeordnet. Die Kanalschicht weist ein Gruppe-III-Nitrid auf und weist an einer Grenzfläche zu der ersten Aluminiumnitridschicht der Abstandshalterstruktur eine zweite freie Ladungsträgerdichte auf. Die erste Aluminiumnitridschicht, die zweite Aluminiumnitridschicht und die Zwischenschicht weisen Schichtdicken auf, so dass die erste freie Ladungsträgerdichte kleiner als 10 % der zweiten freien Ladungsträgerdichte ist.

Ausführungsbeispiele gemäß der Erfindung basieren auf dem Kerngedanken, dass durch die Abstandshalterstruktur der Einfluss der Materialqualität der Barriere nur noch einen geringen Einfluss auf die elektrisch relevanten Eigenschaften der Halbleiterstruktur, z.B. in Form der Ladungsträgerbeweglichkeit in der Kanalschicht, hat. Dadurch kann beispielsweise ein Material für die Barriereschicht verwendet werden, das eine gleiche natürliche Gitterkonstante wie das Material der Kanalschicht aufweist, obwohl solche Materialien oft nur mit deutlich schlechterer Materialqualität hergestellt werden können als andere Materialien mit abweichender Gitterkonstante. Durch die Wahl eines Barrierenmaterials mit gleicher natürlicher Gitterkonstante können innere Spannungen deutlich reduziert werden und dadurch die Lebensdauer von solchen Halbleiterstrukturen bei unveränderter oder nur leicht veränderter Ladungsträgerbeweglichkeit deutlich erhöht werden. Zusätzlich kann die Kanalschicht beispielsweise bei der Herstellung der Barriereschicht durch die Abstandshalterstruktur geschützt werden, wodurch eine hohe Materialqualität der Kanalschicht aufrechterhalten werden kann, welche sich direkt auf die Ladungsträgerbeweglichkeit auswirkt.

Bei einigen Ausführungsbeispielen gemäß der Erfindung ist die Schichtdicke der Zwischenschicht kleiner als zweimal die Schichtdicke der ersten Aluminiumnitridschicht. Dadurch kann bewirkt werden, dass die erste Ladungsträgerdichte in der Zwischenschicht gegenüber der zweiten Ladungsträgerdichte in der Kanalschicht gering gehalten wird. Einige Ausführungsbeispiele gemäß der Erfindung beziehen sich auf eine Halbleiterstruktur, die eine Barriereschicht, eine Abstandshalterstruktur und eine Kanalschicht umfasst. Die Barriereschicht weist als Material AlGaInN oder AlGaN auf und die Kanalschicht weist als Material GaN oder InGaN auf. Die Abstandshalterstruktur umfasst eine erste Aluminiumnitridschicht, eine zweite Aluminiumnitridschicht und eine GaN-Schicht. Die erste Aluminiumnitridschicht und die zweite Aluminiumnitridschicht weisen Schichtdicken zwischen 0,4 nm und 1,4 nm auf. Die GaN-Schicht weist eine Schichtdicke kleiner als 1,5 nm auf. Die GaN-Schicht ist zwischen der ersten Aluminiumnitridschicht und der zweiten Aluminiumnitridschicht angeordnet und weist an einer Grenzfläche zu der zweiten Aluminiumnitridschicht eine erste freie Ladungsträgerdichte auf. Des Weiteren ist die Abstandshalterstruktur zwischen der Barriereschicht und der Kanalschicht angeordnet, und die Kanalschicht weist an einer Grenzfläche zu der ersten Aluminiumnitridschicht der Abstandshalterstruktur eine zweite freie Ladungsträgerdichte auf. Die erste Aluminiumnitridschicht, die zweite Aluminiumnitridschicht und die GaN-Schicht weisen Schichtdicken auf, so dass die erste freie Ladungsträgerdichte kleiner als 10 % der zweiten freien Ladungsträgerdichte ist.

Ausführungsbeispiele gemäß der Erfindung werden nachfolgend Bezug nehmend auf die beiliegenden Figuren näher erläutert. Es zeigen:

Fig. 1    einen schematischen Querschnitt einer Halbleiterstruktur;

Fig. 2    einen schematischen Querschnitt einer Halbleiterstruktur;

Fig. 3    einen schematischen Querschnitt einer Halbleiterstruktur;

Fig. 4    eine Poisson-Schroedinger-Simulation eines Leitungsbands einer beispielhaften Heterostruktur passend zu Fig. 3;

Fig. 5    einen schematischen Querschnitt einer Halbleiterstruktur;

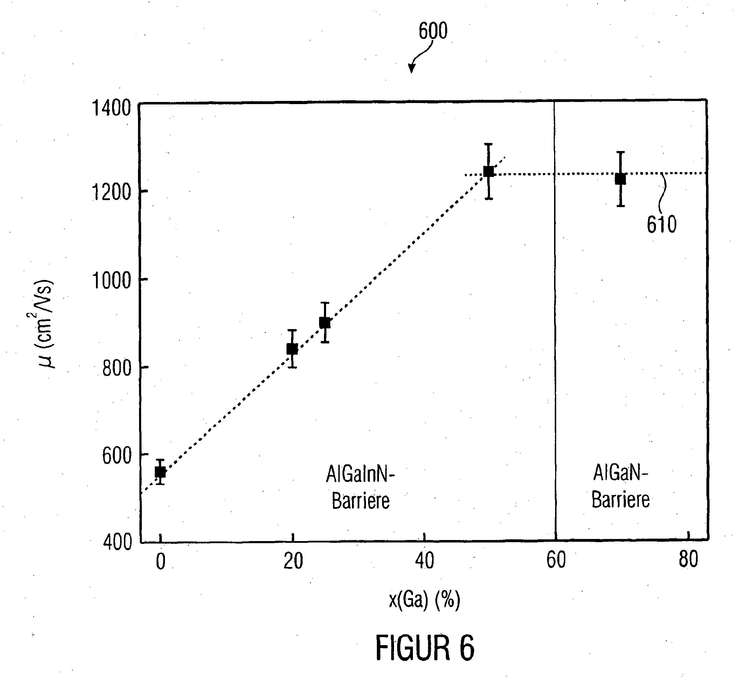

Fig. 6    ein Diagramm der Ladungsträgerbeweglichkeit bei Raumtemperatur bestimmt durch Hall-Messungen an Heterostrukturen; und

Fig. 7    ein Flussdiagramm eines Verfahrens zum Herstellen einer Halbleiterstruktur.

Im Folgenden werden teilweise für Objekte und Funktionseinheiten, die gleiche oder ähnliche funktionelle Eigenschaften aufweisen, gleiche Bezugszeichen verwendet.

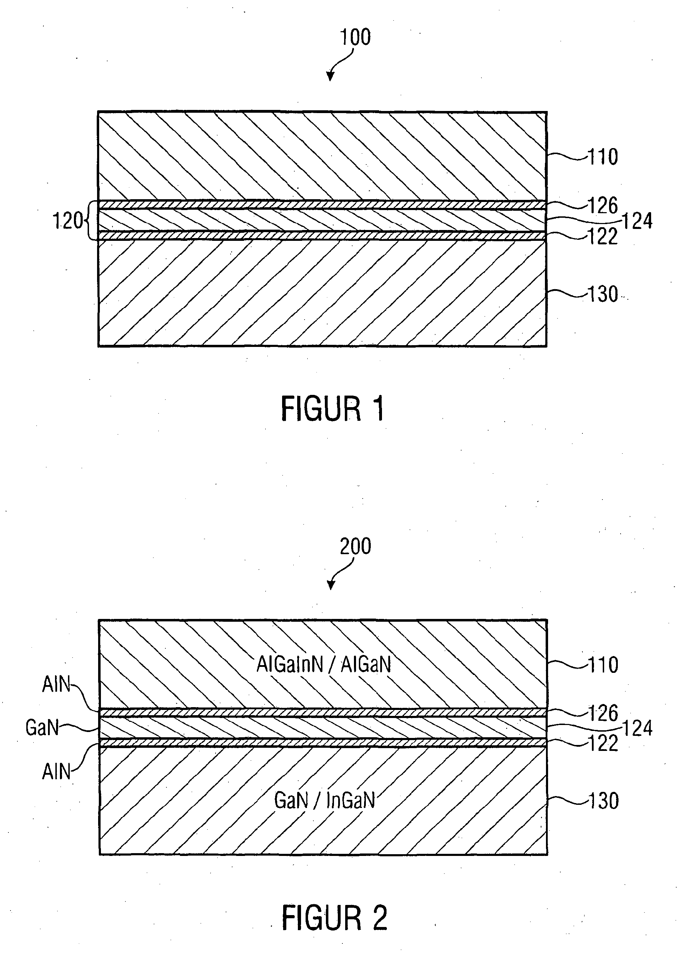

Fig. 1 zeigt einen schematischen Querschnitt einer Halbleiterstruktur 100 entsprechend einem Ausführungsbeispiel gemäß der Erfindung. Die Halbleiterstruktur 100 umfasst eine Barriereschicht 110, eine Abstandshalterstruktur 120 und eine Kanalschicht 130. Die Barriereschicht 110 weist dabei ein Gruppe-III-Nitrid auf. Die Abstandshalterstruktur 120 umfasst eine erste Aluminiumnitridschicht 122, eine Zwischenschicht 124 und eine zweite Aluminiumnitridschicht 126. Die Zwischenschicht 124 weist ein Gruppe-III-Nitrid auf und ist zwischen der ersten Aluminiumnitridschicht 122 und der zweiten Aluminiumnitridschicht 126 angeordnet. Des Weiteren weist die Zwischenschicht 124 an einer Grenzfläche zu der zweiten Aluminiumnitridschicht 126 eine erste freie Ladungsträgerdichte auf. Die Abstandshalterstruktur 120 ist zwischen der Barriereschicht 110 und der Kanalschicht 130 angeordnet. Die Kanalschicht 130 weist so wie die Barriereschicht 110 ein Gruppe-III-Nitrid auf und weist an einer Grenzfläche zu der ersten Aluminiumnitridschicht 122 der Abstandshalterstruktur 120 eine zweite freie Ladungsträgerdichte auf. Die erste Aluminiumnitridschicht 122, die Zwischenschicht 124 und die zweite Aluminiumnitridschicht 126 weisen Schichtdicken auf, so dass die erste freie Ladungsträgerdichte kleiner als 10 % der zweiten freien Ladungsträgerdichte ist.

Ein Gruppe-III-Nitrid ist eine Verbindung eines Elements der Gruppe III des Periodensystems der chemischen Elemente, wie z.B. Aluminium, Gallium oder Indium, mit Stickstoff. Beispiele für Gruppe III-Nitride sind u.a. Aluminiumnitrid AlN, Galliumnitrid GaN, Indiumnitrid InN, Aluminiumgalliumnitrid AlGaN, Galliumindiumnitrid GaInN, Aluminiumindiumnitrid AlInN und Aluminiumgalliumindiumnitrid AlGaInN.

Durch den beschriebenen Schichtaufbau kann sich an der Grenzfläche der Kanalschicht 130 zur ersten Aluminiumnitridschicht 122 der Abstandshalterstruktur 120 ein sogenanntes zweidimensionales Elektronengas (2DEG) ausbilden. Das zweidimensionale Elektronengas hat entlang der Grenzfläche der Kanalschicht 130 in zwei orthogonalen Richtungen eine wesentlich größere Ausdehnung als in einer Richtung senkrecht zur Grenzfläche. Das Maximum der Ladungsträgerdichte des zweidimensionalen Elektronengas muss sich dabei nicht direkt an der Grenzfläche ausbilden, sondern wird sich normalerweise in der Nähe der Grenzfläche innerhalb der zur Grenzfläche orthogonalen Ausdehnung des zweidimensionalen Elektronengases ausbilden. Die zweite freie Ladungsträgerdichte der Kanalschicht 130 kann sich also beispielsweise auf eine freie Ladungsträgerdichte direkt an der Grenzfläche oder auf die maximale freie Ladungsträgerdichte des zweidimensionalen Elektronengases beziehen. Dementsprechend kann sich auch die erste freie Ladungsträgerdichte der Zwischenschicht 124 zum Beispiel auf eine freie Ladungsträgerdichte an der Grenzfläche zu der zweiten Aluminiumnitridschicht 126 oder auf eine maximale freie Ladungsträgerdichte innerhalb der Zwischenschicht 124 beziehen. Die freien Ladungsträger können je nach Materialwahl negative Elektronen oder positive Löcher sein, wobei im folgenden von Elektronen als dominierende freie Ladungsträger ausgegangen wird.

Werden die Schichtdicken der ersten Aluminiumnitridschicht 122, der Zwischenschicht 124 und der zweiten Aluminiumnitridschicht so gewählt, dass die erste freie Ladungsträgerdichte kleiner als 10 % der zweiten freien Ladungsträgerdichte ist, so bildet sich im Vergleich zur Kanalschicht kein oder ein vernachlässigbar kleiner Leitungskanal in der Zwischenschicht 124 der Abstandshalterstruktur 120 aus. Würde sich in der Zwischenschicht 124 ein ausgeprägter Leitungskanal ausbilden, könnte die Materialqualität der Barriereschicht 110 einen genauso negativen Einfluss auf die elektrischen Eigenschaften der Halbleiterstruktur 100 haben als ob die Abstandshalterstruktur 120 nur aus einer einzigen Aluminiumnitridschicht bestehen würde. Ein Leitungskanal in der Zwischenschicht 124 ist daher unerwünscht und kann durch eine geeignete Wahl der Schichtdicken der ersten Aluminiumnitridschicht 122, der Zwischenschicht 124 und der zweiten Aluminiumnitridschicht 126 unterbunden werden. Der Leitungskanal gilt dabei als unterbunden, wenn die erste freie Ladungsträgerdichte kleiner als 10 % der zweiten freien Ladungsträgerdichte ist. Bevorzugt soll die erste freie Ladungsträgerdichte kleiner als 5 %, 2 %, 1 % oder 0,5 % der zweiten freien Ladungsträgerdichte sein.

Durch die Herstellung der Kanalschicht 130 mit möglichst hoher Materialqualität kann eine möglichst hohe theoretische Obergrenze für die Ladungsträgerbeweglichkeit vorgegeben werden. Negative Einflüsse bei der Herstellung der Schichten der Abstandshalterstruktur 120 und der Barriereschicht 110 sowie negative Einflüsse durch die Wahl der Materialien der Abstandshalterstruktur und der Barriereschicht 110 können dazu führen, dass diese theoretische Obergrenze der Ladungsträgerbeweglichkeit nicht erreicht werden kann. Durch die Integration der erfindungsgemäßen Abstandshalterstruktur 120 kann der Einfluss der Materialqualität der Barriereschicht 110 auf die Ladungsträgerbeweglichkeit in der Kanalschicht 130 deutlich reduziert werden. Zusätzlich kann die Kanalschicht 130 bei der Herstellung der Schichten der Abstandshalterstruktur 120 und der Barriereschicht 110 besser geschützt werden, wodurch die Ladungsträgerbeweglichkeit deutlich stärker an die theoretische Obergrenze angenähert werden kann.

Zusätzlich zu den Schichtdicken der ersten Aluminiumnitridschicht 122, der Zwischenschicht 124 und der zweiten Aluminiumnitridschicht 126 kann auch die Wahl der konkreten Gruppe-III-Nitride für die Barriereschicht, die Zwischenschicht und die Kanalschicht einen Einfluss darauf haben, dass die erste Ladungsträgerdichte kleiner als 10 % der zweiten Ladungsträgerdichte ist. Dabei können die Barriereschicht 110, die Zwischenschicht 124 und die Kanalschicht 130 jeweils unterschiedliche, teilweise unterschiedliche oder gleiche Gruppe-III-Nitride aufweisen.

In einigen Ausführungsbeispielen gemäß der Erfindung ist die Zwischenschicht 124 dünner als die doppelte erste Aluminiumnitridschicht. Alternativ ist die Schichtdicke der Zwischenschicht 124 kleiner als 1,9 x die Schichtdicke der ersten Aluminiumnitridschicht abzüglich von 0,1 nm.

Die erste Aluminiumnitridschicht 122 und die zweite Aluminiumnitridschiclit 126 weisen dabei beispielsweise Schichtdicken auf, die größer als 0,4 nm und kleiner als 1,4 nm (oder größer als 0,6 nm und kleiner als 1 nm) sind. Die Zwischenschicht 124 weist beispielsweise eine Schichtdicke kleiner als 1,5 nm (oder kleiner als 1,2 nm, 1 nm oder 0,8 nm) auf

In einigen Ausführungsbeispielen gemäß der Erfindung grenzt die Barriereschicht 110 direkt an die zweiten Aluminiumnitridschicht 126 der Abstandshalterstruktur 120 an. Weist beispielsweise die Barriereschicht 110 als Gruppe-III-Nitrid AlGaInN oder AlGaN auf können dadurch Verspannungen reduziert werden. Würde sich zwischen der Barriereschicht 110 und der zweiten Aluminiumnitridschicht 126 z.B. noch eine GaN-Schicht befinden würde es zwischen dem AlGaInN oder AlGaN der Barriereschicht 110 stets zu Verspannungen kommen. Würde die Abstandshalterstruktur 120 barrierenseitig mit GaN abschließen, wäre auch ein Schutz des Kanals während des Wachstums der Halbleiterstruktur weniger gegeben, da GaN bei typischen Bedingungen während des Wachstums deutlich weniger widerstandsfähig als AlN ist.

Fig. 2 zeigt einen schematischen Querschnitt einer Halbleiterstruktur 200 entsprechend einem Ausführungsbeispiel gemäß der Erfindung. Die Schichtfolge der Halbleiterstruktur 200 entspricht der in Fig. 1 gezeigten Schichtfolge. Die Barriereschicht 110 weist als Gruppe-III-Nitrid AlGaInN oder AlGaN auf. Die Zwischenschicht 124 weist Galliumnitrid auf und kann dementsprechend auch als Galliumnitridschicht bezeichnet werden. Des Weiteren weist die Kanalschicht 130 als Gruppe-III-Element GaN oder InGaN auf. Zusätzlich weisen die erste Aluminiumnitridschicht und die zweite Aluminiumnitridschicht Schichtdicken zwischen 0,4 nm und 1,4 nm auf und die Galliumnitridschicht 124 weist eine Schichtdicke kleiner als 1,5 nm auf. Durch die beschriebene Wahl der Materialien der einzelnen Schichten und der Schichtdicken der Schichten der Abstandshalterstruktur 120 kann gewährleistet werden, dass die erste Ladungsträgerdichte kleiner als 10 % der zweiten Ladungsträgerdichte ist.

Einige Ausführungsbeispiele gemäß der Erfindung beziehen sich auf einen Transistor mit einer Halbleiterstruktur, wie sie in Fig. 1 oder Fig. 2 gezeigt ist. Zusätzlich weist der Transistor einen Source-Kontakt (Quellen-Kontakt), einen Drain-Kontakt (Senken-Kontakt) und einen Gate-Kontakt (Steuerelektrode) auf. Der Source-Kontakt und der Drain-Kontakt sind elektrisch mit der Kanalschicht verbunden. Der Gate-Kontakt ist zwischen dem Source-Kontakt und dem Drain-Kontakt angeordnet und kann die Stromstärke eines elektrischen Stroms zwischen dem Source-Kontakt und dem Drain-Kontakt in der Kanalschicht durch Anlegen eines elektrischen Gate-Potenzials steuern. Der Gate-Kontakt kann direkt auf die Barriereschicht aufgebracht werden, wodurch sich ein Schottky-Kontakt ausbildet. Alternativ kann zwischen dem Gate-Kontakt und der Barriereschicht eine elektrisch isolierende Schicht (Gate-Dielektrikum) hergestellt werden.

Zusätzlich kann die Halbleiterstruktur angrenzend an die Kanalschicht eine Pufferschicht und angrenzend an die Pufferschicht ein Substrat aufweisen. Das Substrat dient als Trägermaterial, auf dem die Pufferschicht aufgebracht werden kann. Die Pufferschicht kann dazu verwendet werden, um Substrateinflüsse auf das aktive Bauelement (z.B. Transistor) zu unterdrücken und ein möglichst perfektes Kristallgitter für das weitere Kristallwachstum bereitzustellen.

Die nachfolgende Kanalschicht wird von oben mit der nachfolgenden Abstandshalterstruktur gefolgt von der Barriereschicht begrenzt. Aufgrund der unterschiedlichen Austrittsarbeiten und Bandabstände bildet sich ein Potenzialtopf im Leitungsband an der Grenzfläche zwischen der Kanalschicht und der ersten Aluminiumnitridschicht aus, in dem sich die Elektronen aufgrund günstigerer energetischer Verhältnisse bevorzugt aufhalten. Weil aufgrund der geringen Breite des Potenzialtopfes die freien Bewegungsrichtungen der Ladungsträger auf nur zwei Raumrichtungen beschränkt sind, nennt man diesen Bereich auch zweidimensionales Elektronengas. Wenn sich das zweidimensionale Elektronengas in einer beispielsweise undotierten Kanalschicht befindet, treten beim Ladungstransport im Vergleich zu beispielsweise dotierten Schichten, kaum Streuprozesse bedingt durch die ionisierten Donator-Rümpfe auf, was zu sehr guten Transporteigenschaften (z.B. hohe Ladungsträgerbeweglichkeit) führt.

Über eine Spannung an dem Gate-Kontakt, die beispielsweise durch einen sperrenden Schottky-Kontakt realisiert wird, lässt sich die Lage des Potenzialtopfs relativ zum Fermi-Niveau einstellen und somit die Konzentration der Ladungsträger im zweidimensionale Elektronengas steuern. Im Bereich des Source-Kontakts und des Drain-Kontakts kann sich auf der Barriereschicht noch eine hoch dotierte Schicht befinden, die dazu dient, den Ohmschen Kontakt des Drain-Kontakts und des Source-Kontakts zu verbessern.

Solche Transistoren werden auch Heterostruktur-Feldeffekttransistoren genannt.

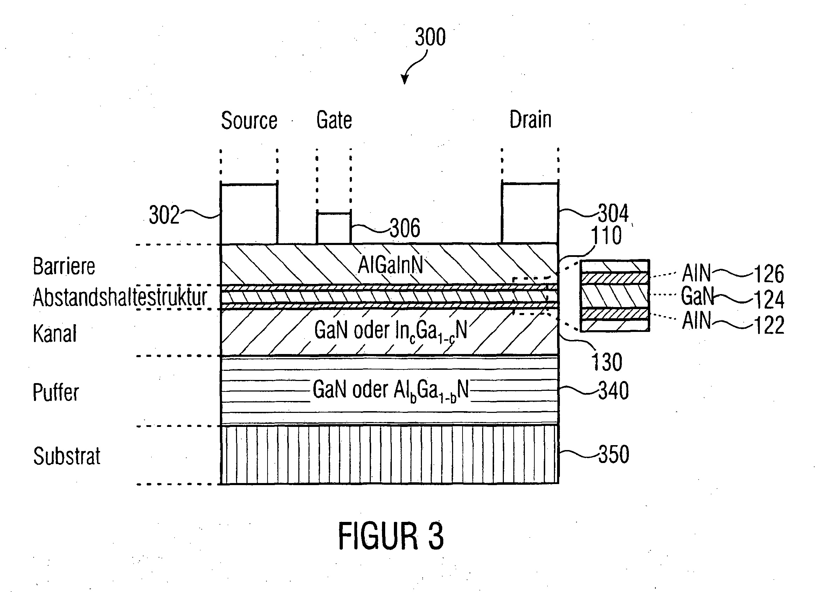

Fig. 3 zeigt einen schematischen Querschnitt einer Halbleiterstruktur 300 entsprechend einem Ausführungsbeispiel gemäß der Erfindung. Die Halbleiterstruktur 300 weist einen Schichtaufbau entsprechend der Halbleiterstruktur, wie sie in Fig. 1 gezeigt ist, auf. Zusätzlich umfasst die Halbleiterstruktur 300 angrenzend an die Kanalschicht 130 eine Pufferschicht 340 und daran angrenzend ein Substrat 350, wie sie bereits zuvor beschrieben würden. Die Halbleiterstruktur 300 kann beispielsweise, wie durch den Source-Kontakt 302, den Drain-Kontakt 304 und den Gate-Kontakt 306 angedeutet, weiter prozessiert werden, um einen Heterostruktur-Feldeffekttransistor herzustellen.

Die schematische Darstellung dieses Ausführungsbeispiels ist nicht maßstabsgetreu.

Bei der Herstellung der Halbleiterstruktur 300 wird beispielsweise zuerst auf dem Substrat 350 die Pufferschicht 340 gefolgt von der Kanalschicht 130 aufgewachsen. Auf der Kanalschicht 130 werden die Schichten der Abstandshalterstruktur 120 in Form der ersten Aluminiumnitridschicht 122, der Zwischenschicht 124 und der zweiten Aluminiumnitridschicht 126 aufgebracht. Danach wird die Barriereschicht 110 aufgewachsen.

In diesem Beispiel besteht der Abstandshalter oder die Abstandshalterstruktur 120 aus einer Aluminiumnitridschicht, gefolgt von einer Galliumnitridschicht, gefolgt von einer weiteren Aluminiumnitridschicht. Alle drei Teilschichten weisen Dicken zwischen mehreren Angström und einigen wenigen Nanometern, jedoch üblicherweise um oder unter 1 nm auf. Geeignete Dicken können abgesehen von anderen Verfahren anhand von beispielsweise Poisson-Schroedinger-Simulationen ermittelt werden, um die Variation der Leitungsbandenergie in Bezug auf die Tiefe zu optimieren und zu gewährleisten, dass kein zweites zweidimensionales Elektronengas in der Galliumnitridteilschicht (der Zwischenschicht) gebildet wird.

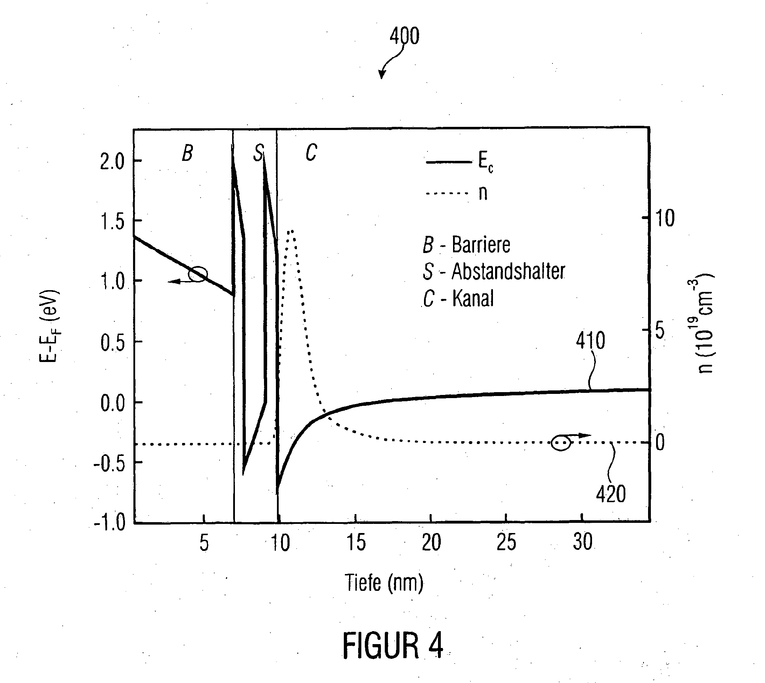

Fig. 4 zeigt dazu ein Beispiel einer Poisson-Schroedinger-Simulation 400 eines Leitungsbands 410 und einer Ladungsträgerdichte 420 für eine beispielhafte Heterostruktur entsprechend dem in Fig. 3 gezeigten Beispiel. Das Diagramm 400 zeigt auf der x-Achse die Tiefe gemessen in Nanometer in Bezug auf die kanalabgewandte Oberfläche der Barriereschicht. Die y-Achse zeigt einerseits für das Leitungsband die Energiedifferenz zwischen der Energie E und der Fermi-Energie $E_f$ in Elektronenvolt und andererseits die Ladungsträgerdichte n in Einheiten von $10^{19}$ cm$^{-3}$. Die Ladungsträgerdichte zeigt ein deutliches Maximum in der Nähe der Grenzfläche der Kanalschicht zu der ersten Aluminiumnitridschicht. Die beiden Aluminiumnitridschichten weisen eine ausreichende Dicke auf und die Zwischenschicht ist ausreichend dünn, so dass sich in der Zwischenschicht nur eine im Vergleich zur Ladungsträgerdichte der Kanalschicht vernachlässigbare Ladungsträgerdichte ausbildet. Die Barriereschicht hat einen größeren Bandabstand als die Kanalschicht, wodurch auch in der Barriereschicht eine wesentlich geringere freie Ladungsträgerdichte als in der Kanalschicht vorhanden ist. Wie in Fig. 4 zu sehen ist, weist das Leitungsband ein Energieminimum im Bereich der Kanalschicht (in der Nähe der Grenzfläche zu der Abstandshalterstruktur) auf.

In dem in Fig. 3 gezeigten Ausführungsbeispiel ist die Barriereschicht aus $Al_xGa_{1-x-y}In_yN$ bei einer Zusammensetzung, die an Galliumnitrid nahezu angepasst ist, hergestellt. Das Verhältnis x/y ist beispielsweise im Bereich zwischen 4,5 und 5. Unter diesen Bedingungen kann die Galliumkonzentration 1-x-y z.B. von 0 bis 0,9 variieren, was beispielsweise auch AlInN einschließt, das bezüglich Galliumnitrid gitterangepasst ist. Gitterangepasst bedeutet in dem Zusammenhang beispielsweise, dass die natürlichen Gitterkonstanten der Materialien gleich oder annähernd gleich sind. Die AlGaInN-Schicht (Bärriereschicht) weist z.B. eine Dicke um oder unterhalb von 10 nm auf. Die Dicke und die Zusainmensetzung des AlGaInN (Barriereschicht), speziell seiner Galliumkonzentration, kann variiert werden, um die Flächenelektronendichte des zweidimensionalen Elektronengases, die Barrierenhöhe an dem Gate-Kontakt, die Schwellenspannung des HFET einzustellen und/oder den Ohmschen Anschlusswiderstand zu optimieren.

Bei alternativen Ausführungsbeispielen kann der Abstandshalter (Abstandshalterstruktur) auf einer willkürlichen Anzahl von Teilschichten, die größer oder gleich 3 ist, bestehen, wobei die erste und die letzte Teilschicht aus Aluminiumnitrid hergestellt sind. Die Al-GaInN-Schicht (Barriereschicht) kann auch Dicken von mehr als 10 nm aufweisen, um sie bezüglich einer Ladungsträgerbegrenzung statt einer Skalierbarkeit zu optimieren. Abweichungen von den gitterangepassten Bedingungen, bei denen x/y außerhalb des Bereichs zwischen 4,5 und 5 liegt, können dazu verwendet werden z.B. die Schwellenspannung einzustellen.

Die Kanalschicht 130 kann beispielsweise Galliumnitrid oder $In_cGa_{1-c}N$ aufweisen und die Pufferschicht 340 kann Galliumnitrid oder $Al_bGa_{1-b}N$ aufweisen.

Mögliche Schichtdickenkombinationen des Abstandshalters (der Abstandshalterstruktur) können mittels Simulation ermittelt werden. Verlangt man beispielsweise eine Ladungsträgerkonzentration von unter $10^{18}$ cm$^{-3}$ in der Galliumnitrid-Zwischenschicht 124, so dass sich dann z.B. deutlich weniger als 1 % Ladungsträger pro Fläche in dieser Schicht verglichen zum Kanal befinden, ergibt sich z.B. näherungsweise folgender Zusammenhang:

$$d(GaN, Zwischenschicht) < (1,9 \times d(AlN, kanalseitig) - 0,1 \ nm)$$

In anderen Worten, die Schichtdicke der Zwischenschicht 124 ist kleiner als das 1,9-fache der Schichtdicke der ersten Aluminiumnitridschicht abzüglich von 0,1 nm. Diese Angaben gelten beispielsweise für eine feste Dicke der barriereseitigen Aluminiumnitridschicht (der zweiten Aluminiumnitridschicht) und der Barriere. Da auch ein Anteil von mehreren Prozent an Ladungsträgern (< 10 %) in der Galliumnitrid-Zwischenschicht noch zulässig sein kann, können die Schichtdicken der Zwischenschicht und der ersten Aluminiumnitridschicht auch beispielsweise nach folgender Beziehung gewählt werden:

$$d(GaN, Zwischensicht) < 2 \times d(AlN, kanalseitig)$$

In anderen Worten, die Schichtdicke der Zwischenschicht ist kleiner als die doppelte Schichtdicke der ersten Aluminiumnitridschicht.

In dem beschriebenen Ansatz dient die AlN/GaN/AlN-Schichtfolge als Abstandshalterstruktur, um beispielsweise negative Einflüsse der Barriere auf die Elektronen im Kanal zu verringern. Die Ladungsträgerdichte in der GaN-Zwischenschicht ist in diesem Design minimal gehalten. In dem in Fig. 3 gezeigten Beispiel beträgt die Ladungsträgerdichte pro Fläche im eigentlichen Kanal beispielsweise etwa $2 \times 10^{13}$ cm$^{-2}$ und in der z.B. 1,4 nm dicken Galliumnitrid-Zwischenschicht (als Teil der Abstandshalterstruktur) nur knapp $5 \times 10^{10}$ cm$^{-2}$, also etwa 0,25 %. Dennoch ist es natürlich denkbar, aufgrund anderer Anforderungen ein Design (Schichtdicken) zu wählen, das relativ mehr Ladungsträger in der Zwischenschicht enthält, beispielsweise bis zu einigen Prozent, jedoch kleiner als 10 %.

Allgemein ergibt sich das Ladungsträgerprofil, d.h. die Ladungsträgerdichte in Abhängigkeit von der Position, aus dem Leitungsbandverlauf (conduction band edge), wie es beispielsweise in Fig. 4 gezeigt ist. Je tiefer die Leitungsbandkante energetisch liegt, desto größer ist an diesem Ort die Ladungsträgerdichte. Betrachtet man eine Schichtfolge bestehend aus AlN (barrierenseitig)/GaN/AlN (kanalseitig), können folgende Einflüsse bestehen: je größer die Schichtdicke des kanalsseitigen Aluminiumnitrids ist, desto kleiner ist die Ladungsträgerdichte in der Galliumnitridschicht. Das dickere Aluminiumnitrid "hebt" das Leitungsband im Galliumnitrid energetisch an. Außerdem gilt, je größer die Schichtdicke der Galliumnitridschicht ist, desto größer ist auch die Ladungsträgerdichte innerhalb dieser, da ein zunehmender Bereich des Galliumnitrids mit dem Leitungsband bei niedrigen Energien liegt. Ein Beispiel für eine Wahl der Schichtdicken der Abstandshalterstruktur ist 0,7 nm Aluminiumnitrid (barrierenseitig) / 1,4 nm GaN / 0,8 nm AlN (kanalseitig). Die beschriebenen Zusammenhänge gelten beispielsweise für sogenannte Gruppe-IIIpolare Materialien (III-face oder auch Ga-face genannt), wie es beispielsweise bei nitridischen Transistoren verwendet wird. Verwendet man z.B. sogenanntes N-polares Material (N-face), gelten andere Zusammenhänge.

Der Abstandshalter (spacer) dient z.B. dazu, durch seine Stabilität und seine elektronischen Eigenschaften den Kanal sowohl beim Wachstum als auch in der fertigen Struktur vor negativen Einflüssen der Barriere zu schützen. Auch wenn die Barriere, wie z.B. bei AlGaN eine andere natürliche, sogenannte relaxierte, Gitterkonstante als der Kanal besitzt, erfolgt stets ein verspanntes, sogenanntes pseudomorphes, Wachstum der Barriere (wie auch des Abstandshalters). D.h. die laterale Gitterkonstante (parallel zu den Schichten) der Barriere wird auf den des Kanals gedehnt oder gestaucht. Die Barriere steht dann permanent unter mechanischer Spannung.

Eine längere Lebensdauer kann erwartet werden, wenn man ein Barrierematerial wählt, das die gleiche laterale Gitterkonstante (natürliche Gitterkonstante) wie der Kanal besitzt. Dann ist die Struktur verspannungsfrei (abgesehen von den dünnen Aluminiumnitridschichten des Abstandshalters). Allerdings können solche gitterangepasste Verbindungen nur schwer oder gar nicht in vergleichbarer Qualität, wie zum Beispiel AlGaN, hergestellt werden. Verwendet man jedoch den beschriebenen Abstandshalter (Abstandshalterstruktur), hat die Materialqualität der Barrieren nur noch einen geringen Einfluss auf die elektrisch relevanten Eigenschaften der Struktur. Die Materialqualität bezieht sich dabei beispielsweise auf die Homogenität der Barriere oder andere Wachstumseffekte und die elektrisch relevanten Eigenschaften der Struktur sind beispielsweise die Ladungsträgerbeweglichkeit in der Kanalschicht.

Die Verwendung von drei Schichten in der Abstandshalterstruktur anstelle von beispielsweise einer dicken Aluminiumnitridschicht ist notwendig, da Aluminiumnitridschichten mit einer Dicke von mehr als etwa 1,4 nm auf der Kanalschicht wegen unterschiedlicher Gitterkonstanten nur schwer herstellbar sind. Die Auswahl von Galliumnitrid als Material der Zwischenschicht kann vorteilhaft sein, da es sich mit großer Qualität herstellen lässt, und zusätzlich, je nach Material der Kanalschicht, eine gleiche natürliche Gitterkonstante wie die Kanalschicht aufweist.

Alternativ zu Galliumnitrid kann auch AlGaN als Material für die Zwischenschicht verwendet werden, welches weniger freie Ladungsträger als GaN zur Verfügung stellt und daher unter gleichen Bedingungen eine geringere Ladungsträgerdichte aufweist. Dafür kann AlGaN Nachteile bezüglich der Materialqualität und/oder der natürlichen Gitterkonstante im Vergleich zur Kanalschicht gegenüber GaN haben.

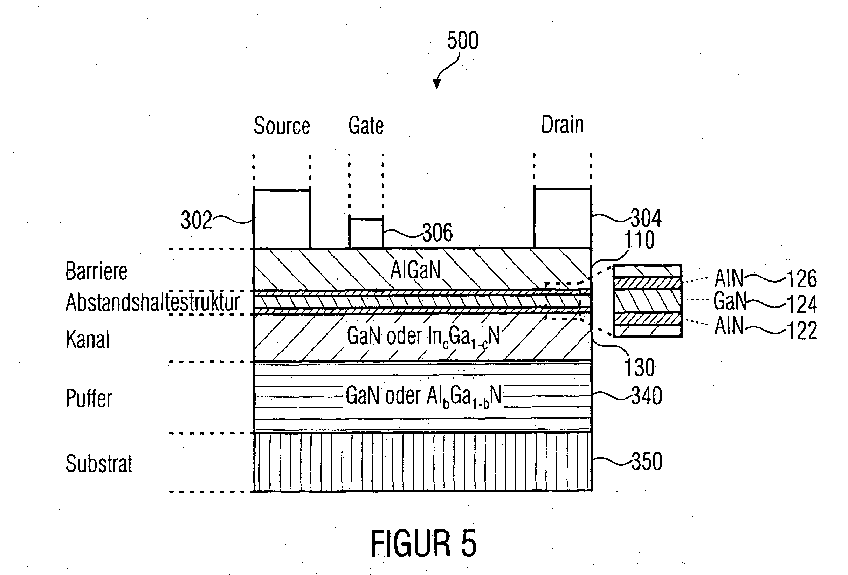

Alternativ zeigt Fig. 5 einen weiteren schematischen Querschnitt einer Halbleiterstruktur 500 entsprechend einem Ausführungsbeispiel gemäß der Erfindung. Die Halbleiterstruktur 500 entspricht der in Fig. 3 gezeigten Halbleiterstruktur, jedoch wird der Abstandshalter (Abstandshalterstruktur) auch mit einer AlGaN-Barriereschicht kombiniert. Ähnlich dem vorherigen Ausführungsbeispiel wird der Abstandshalter auf den Kanal gewachsen, und die AlGaN-Barriereschicht wird auf den Abstandshalter gewachsen.

Ebenso wie Fig. 3 ist die schematische Zeichnung von Fig. 5 nicht maßstabsgetreu.

Allgemein wird die Abstandshalterstruktur auf den Kanal (Kanalschicht) gewachsen, in welchem das zweidimensionale Elektronengas durch die Polarisation des Abstandshalters und der Barriereschicht induziert wird. Bei manchen Ausführungsbeispielen ist der Kanal aus Galliumnitrid hergestellt. Bei anderen Ausführungsbeispielen kann der Kanal aus $In_cGa_{1-c}N$ hergestellt sein, wobei c den Bereich von beispielsweise 0 bis 0,2 abdeckt. In beiden Fällen kann der Kanal auf einer Pufferschicht gewachsen werden, die beispielsweise aus Galliumnitrid oder aus $Al_bGa_{1-b}N$ hergestellt werden kann, wobei b z.B. im Bereich von 0 bis 0,1 liegt. Eine aus InGaN hergestellte Zwischenschicht kann optional als elektrische Rückseitenbarriere zwischen Kanal (Kanalschicht) und Puffer (Pufferschicht) eingefügt sein. Die Pufferschicht kann optional eine Dotierung aufweisen, um eine Isolierung zu verbessern oder Zwischenschichten und/oder Mikro- oder Nanostrukturen aufweisen, um Defekte zu verringern. Ferner kann die Pufferschicht auf einem Substrat, optional unter Verwendung einer Keimbildungsschicht, gewachsen werden. Das Substratmaterial kann beispielsweise Siliziumkarbid SiC, Saphir, Silizium, Bulk-GaN (Volumen-GaN) oder Bulk-AlN (Volumen-AlN) sein.

Bei einigen Ausführungsbeispielen kann auf die Barriereschicht optional eine Abdeckung aufgewachsen werden, die aus einer einzigen Schicht oder aus mehreren Schichten besteht. Auch können bei Ausführungsbeispielen ein, einige oder alle Abschnitte der Heterostruktur, z.B. der Puffer, der Kanal, der Abstandshalter, die Barriere und/oder die Abdeckung in der Reihenfolge des Aufwachsens unabsichtlich oder absichtlich dotiert werden, was auch ein moduliertes Dotierungsprofil in der Barriereschicht einschließt.

Das Aufwachsen der Heterostruktur kann unter Verwendung einer beliebigen geeigneten Technik, die mit ausreichender Materialqualität und Dickengenauigkeit durchgeführt werden, einschließlich, jedoch nicht beschränkt auf, Molekularstrahlepitaxie (MBE, molecular beam epitaxy) oder metallorganische chemische Gasphasenabscheidung (MOCVD, metal-organic chemical vapor deposition), auch als metallorganische Gasphasenepitaxie (MOVPE, metalorganic vapor phase epitaxy) bezeichnet, durchgeführt werden.

Unter Verwendung von Heterostrukturen oder Halbleiterstrukturen, wie sie oben beschrieben wurden, können HFET-Bauelemente durch die Aufbringung von Ohmschen Source- und Drain-Kontakten und eines Gate-Kontakts zwischen Source und Drain auf der Oberfläche der Halbleiterheterostruktur hergestellt werden. Vor der Aufbringung eines jeglichen der Kontakte kann in ausgewählten Bereichen eine optionale Aussparungsätzung durchgeführt werden. Eine optionale Isolierungsschicht kann zwischen dem Gate-Kontakt und der Halbleiteroberfläche eingefugt werden. Die Bauelemente können unter Verwendung von Verfahren, wie beispielsweise Mesa-Ätzung oder Ionenimplantation, lateral isoliert werden. Weitere Komponenten, wie beispielsweise Passivierungsschichten, Gateköpfe und/oder Feldplatten, können als Teil des Bauelementprozesses hinzugefügt werden.

Bei einigen Ausführungsbeispielen gemäß der Erfindung ergeben sich aus den Auswirkungen des Abstandshalters (Abstandshalterstruktur), beispielsweise in Kombination mit einer quaternären Barriereschicht mit einer geeigneten Zusammensetzung, Vorteile. Diese ermöglicht beispielsweise die Verwirklichung einer dünnen Barriereschichtdicke zusammen mit einer hohen Flächenladungsträgerdichte und einer hohen Elektronenbeweglichkeit. Dadurch können auch kurze Gate-Längen, die für Hochgeschwindigkeitsanwendungen wesentlich sind, genutzt werden.

Durch Verwendung eines AlN/GaN/AlN-dreifach Schichtabstandshalters, wie er beispielsweise im Zusammenhang mit dem in Fig. 3 gezeigten Ausführungsbeispiel beschrieben wurde, kann die Trennung zwischen dem zweidimensionalen Elektronengas in dem Kanal und der Barriereschicht im Vergleich zu einer einzigen Aluminiumnitrid-Zwischenschicht erhöht werden, wobei gleichzeitig die Spannung auf einem moderaten Niveau gehalten wird, da die mittlere GaN-Schicht (Zwischenschicht) bei einer GaNbasierten Struktur natürlich gitterangepasst ist. Auch weisen die Aluminiumnitridschichten eine Dicke von beispielsweise 0,6 nm bis 0,7 nm auf, was bedeutend weniger ist als eine typische bekannte Aluminiumnitrid-Zwischenschicht mit einer Dicke von 1 bis 1,5 nm, wodurch z.B. die Entstehung von Defekten in den Aluminiumnitridschichten verhindert werden kann. Außerdem kann der Dreifachschichtabstandshalter einen Schutz der darunter liegenden Schichten bieten, wenn das Aufwachsen nach dem Abstandshalter fortgeführt wird. Dies kann besonders dann von Vorteil sein, wenn eine gitterangepasste AlInN- oder AlGaInN-Schicht aufgewachsen wird. Aufgrund von relativ geringen Wachstumstemperaturen der Barriereschicht kann eine Wachstumsunterbrechung erforderlich sein, um die Substrattemperatur stufenförmig zu senken. Während der Unterbrechung kann der Kanal durch Defekte, die durch eine Oberflächenverschlechterung und die übergebliebenen Reaktorgase verursacht werden, und später durch eine Barriereschicht induzierte- Verschlechterung, die auf Defekte, z.B. in dem AlGaInN-Material zurückzuführen sind, beschädigt werden. Experimente zeigen, dass schädliche Barriereschichteinflüsse auf die 2DEG-Beweglichkeit bei Strukturen mit einem Dreifachschichtabstandshalter beträchtlich geringer sind, als bei solchen mit einer einzigen Aluminiumnitrid-Zwischenschicht. Deshalb trägt der Dreifachschichtabstandshalter (die Abstandshalterstruktur) wesentlich dazu bei, die Verwendung einer gitterangepassten Barriereschicht durchführbar zu machen. Jedoch ist das Abstandshaltersubstrat, wie bereits erwähnt, nicht auf drei Schichten beschränkt, sondern kann auch mehr als drei Schichten aufweisen.

Eine AlGaInN-Barriereschicht mit geeigneter Zusammensetzung kann mehrere Vorteile gegenüber sowohl AlGaN- als auch AlInN-Barriereschichten liefern. Erstens kann die Gitteranpassung von AlGaInN, wie sie im Zusammenhang mit beispielsweise dem in Fig. 3 gezeigten Ausführungsbeispiel beschrieben wurde, im Gegensatz zu AlGaN eine verspannungsfreie Barriereschicht bieten. Daher werden weniger Liniendefekte während des Wachstums in das Material eingebracht, was robustere Bauelemente ermöglichen kann. Die Gitteranpassung der Barriereschicht kann für Doppel-Heterostruktür-Entwürfe mit einem AlGaN-Puffer ohne Weiteres angepasst werden. Zweitens verbessert sich die Mischbarkeit von AlGaInN mit zunehmenden Galliumgehalt (siehe z.B. "Matsuoka, Appl. Phys. Lett. 71, 105 - 106 (1997)", so dass die Materialqualität besser ist als die von AlInN. Als direkte Auswirkung kann die Beweglichkeit bei AlGaInN-basierten Heterostrukturen mit der Galliumkonzentration zunehmen und wird bei etwa 50 % Gallium vergleichbar mit AlGaN/GaN-Strukturen. Bei dieser gitterangepassten AlGaInN-Zusammensetzung liegt die Aluminiumkonzentration immer noch oberhalb von 40 %, so dass eine dünne Barriereschicht, die eine Dicke von weniger als 10 nm aufweist, zusammen mit dem Abstandshalter eine 2DEG-Dichte (zweite freie Ladungsträgerdichte) von mehr als $2 \times 10^{13}$ cm$^{-2}$ bewirken kann. Die bessere Mischbarkeit von AlGaInN im Vergleich zu AlInN kann ferner höhere Wachstumstemperaturen ermöglichen, was eine unbeabsichtigte Einbringung von Verunreinigungen verringern und die kristalline Qualität verbessern kann. Drittens kann aufgrund der moderaten Aluminiumkonzentration von AlGaInN die Metallurgie von Titan/Aluminium-basierten Ohmschen Source- und Drain-Kontakten im Vergleich zu AlInN vorteilhafter sein (siehe dazu "Lu et al., IEEE Trans. Electron Devices 50, 1069 - 1074 (2003)"). Dies kann für geringere Anschlusswiderstände, die für HFETs mit verbesserter Leistungsfähigkeit und Hochfrequenzfähigkeit benötigt werden, vorteilhaft sein.

Fig. 4 zeigt dazu beispielsweise die Beweglichkeit 610 bei Raumtemperatur bestimmt durch Hall-Messurigen an Heterostrukturen entsprechend dem Ausführungsbeispiel von Fig. 3. Das Al/In-Verhältnis in AlGaInN ist dabei 4,8. Bei 50 % Galliumkonzentration ist die Beweglichkeit nur durch die Qualität des GaN-Kanals der Struktur und nicht durch Barriere-bezogene Defekte begrenzt. In dem Diagramm 600 ist auf der X-Achse die Galliumkonzentration x(Ga) in % und auf der Y-Achse die Ladungsträgerbeweglichkeit $\mu$ in cm$^2$/Vs dargestellt.

Das in Fig. 3 gezeigte Ausführungsbeispiel kann unter Verwendung der kombinierten Vorteile eines Mehrschichtabstandshalters und einer AlGaInN-Barriereschicht in einem geeigneten Zusammensetzungsfensters eine nahezu verspannungsfreie Halbleiter-Heterostruktur ermöglichen, die gleichzeitig eine hohe zweidimensionale Elektronengas-Dichte und zweidimensionale Elektronengas-Beweglichkeit, eine dünne Barriereschicht für eine gute Skalierbarkeit mit der Gate-Länge und/oder einen geringen Anschlusswiderstand für Ohmsche Kontakte liefert.

Das Ausführungsbeispiel, wie es in Fig. 5 gezeigt ist, kann sowohl die zweidimensionale Elektronengas-Dichte als auch die zweidimensionale Elektronengas-Beweglichkeit von AlGaN-basierten Strukturen verbessern. Aufgrund der Trennung zwischen den 2DEG und der Barriereschicht wird beispielsweise der Einfluss einer Legierungsstreuung verringert, indem der Abstandshalter eingeführt wird. Wie oben beschrieben wurde, ist im Vergleich zu einer einzigen AlN-Zwischenschicht eine größere Trennung möglich, ohne die Verspannung in der Struktur zu erhöhen. Überdies kann der Leitungsbandabstand hinsichtlich der Barriere durch den Abstandshalter vergrößert werden, so dass die Ladungsträgerbeschränkung des zweidimensionalen Elektronengases verbessert werden kann.

Einige Ausführungsbeispiele gemäß der Erfindung beziehen sich auf die Verwendung von AlGaN als Barriereschicht. Mit verbesserter Materialqualität, beispielsweise durch weitere verringerte Defektdichte, kann die Robustheit und Zuverlässigkeit derartiger AlGaNbasierten Bauelementen verbessert werden, so dass sie mit gitterangepassten Strukturen, die üblicherweise eine höhere Defektdichte aufweisen, vergleichbar sind oder sogar besser sind als diese.

Ferner kann beispielsweise AlInN als Barrierenmaterial verwendet werden. Durch Verbesserung der Materialqualität von ternären AlInN können höhere zweidimensionale Elektronengas-Beweglichkeiten erzielt werden. Aufgrund seiner Nicht-Mischbarkeit erscheint es jedoch schwierig, dass AlInN in ähnlicher Qualität wie AlGaN oder AlGaInN mit ausreichender Galliumkonzentration gewachsen werden kann.

Die Vorteile von AlInN, vor allem die Herstellung von nahezu verspannungsfreien Heterostrukturen mit hohen Flächenelektronendichten, können beibehalten werden, indem ausreichend aluminiumreiches quaternäres AlGaInN bei einem Al/In-Verhältnis von etwa 4,7 verwendet wird, das Verbindungen liefert, die bezüglich GaN gitterangepasst sind. Eine Heterostruktur auf Basis von gitterangepassten AlGaInN mit einem Aluminiumgehalt von mehr als 30 % und einer guten Beweglichkeit kann möglich sein.

Einige Ausführungsbeispiele gemäß der Erfindung beziehen sich auf einen Nitrid-basierten Heterostruktur-Feldeffekttransistor.

Das beschriebene erfindungsgemäße Konzept umfasst eine Halbleiter-Heterostruktur, die einen auf einem Kanal gewachsenen Mehrschichtabstandshalter und eine auf dem Abstandshalter gewachsene Barriereschicht umfasst. Diese Heterostruktur kann verarbeitet werden, um ein HFET-Bauelement herzustellen.

Nitrid-HFET-Strukturen mit gitterangepassten Schichten, einer dünnen Barriereschicht, einer hohen 2DEG-Dichte und 2DEG-Beweglichkeit und/oder einem geringen Anschlusswiderstand, wie sie beispielsweise in dem Ausführungsbeispiel von Fig. 3 (und Fig. 5) beschrieben wurden, sind Kandidaten für Leistungsanwendungen bei hohen Frequenzen bis hinauf in den Millimeterwellenlängenbereich. Während Nitride der Gruppe III die höchste Leistungsdichte im Bereich oberhalb von 1 GHz aller derzeitiger Materialsysteme für Halbleiterleistungsverstärker ermöglichen, decken etablierte Anwendungen meist den Bereich zwischen 2 und 12 GHz ab. Bei höheren Frequenzen, beispielsweise um 35 GHz und 94 GHz für Radar mit einer hohen räumlichen Auflösung, können Nitrid-HFETs Leistungspegel bieten, die bisher für Festkörpersysteme nicht zugänglich sind. Höhere Leistungen sind auch für Abstandserfassungsanwendungen im Millimeterwellenlängenbereich interessant.

Gitterangepasste Strukturen weisen u.a. den Vorteil einer höheren Robustheit auf, was bei einer Verwendung unter widrigen Bedingungen, beispielsweise bei hohen Temperaturen oder bei hoher Trägheits- und Erschütterungsbeanspruchung, wie z.B. bei in der Luft befindlichen Systemen, von Nutzen ist. Auch für Leistungselektronik ist die höhere Robustheit von verspannungsfreien Strukturen vorteilhaft. Für typische Mikrowellenanwendungen, beispielsweise Mobilkommunikations-Basisstationen und Radarmodulen, kann die Verwendung von gitterangepassten Strukturen die Zuverlässigkeit und Lebensdauer verbessern.

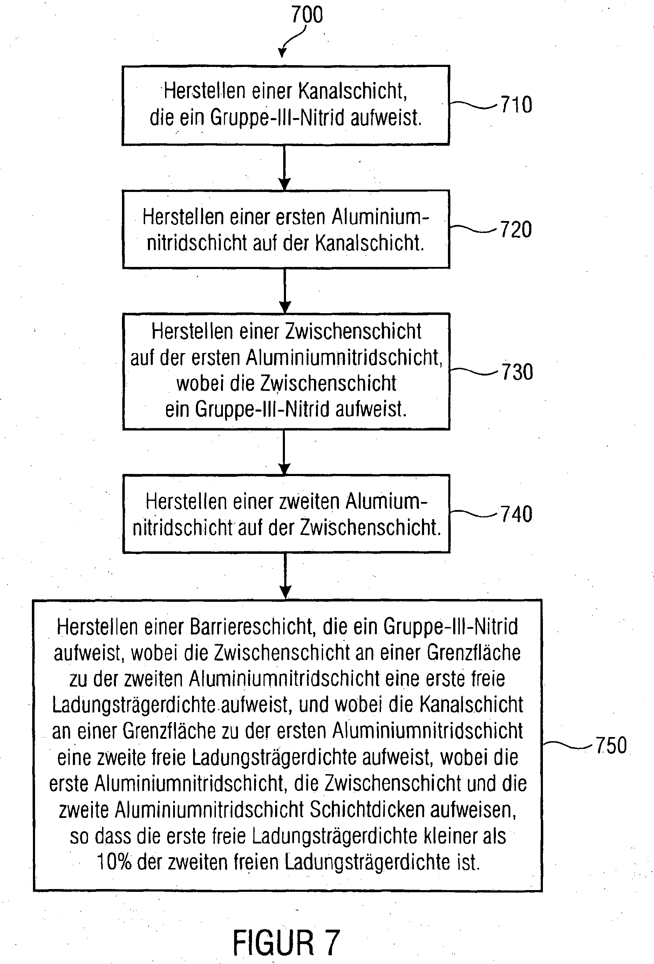

Fig. 7 zeigt ein Flussdiagramm eines Verfahrens 700 zur Herstellung einer Halbleiterstruktur entsprechend einem Ausführungsbeispiel gemäß der Erfindung. Das Verfahren 700 umfasst ein Herstellen 710 einer Kanalschicht, ein Herstellen 720 einer ersten Aluminiumnitridschicht auf der Kanalschicht, ein Herstellen 730 einer Zwischenschicht auf der ersten Aluminiumnitridschicht, ein Herstellen 740 einer zweiten Aluminiumnitridschicht auf der Zwischenschicht und ein Herstellen 750 einer Barriereschicht auf der zweiten Aluminiumnitridschicht. Die Zwischenschicht weist an einer Grenzfläche zu der zweiten Aluminiumnitridschicht eine erste freie Ladungsträgerdichte auf und die Kanalschicht weist an einer Grenzfläche zu der ersten Aluminiumnitridschicht eine zweite freie Ladungsträgerdichte auf. Die erste Aluminiumnitridschicht, die zweite Aluminiumnitridschicht und die Zwischenschicht weisen Schichtdicken auf, so dass die erste freie Ladungsträgerdichte kleiner als 10 % der zweiten freien Ladungsträgerdichte ist. Die Barriereschicht, die Zwischenschicht und die Kanalschicht weisen ein Gruppe-III-Nitrid auf.

Obwohl manche Aspekte im Zusammenhang mit einer Vorrichtung beschrieben wurden, versteht es sich, dass diese Aspekte auch eine Beschreibung des entsprechenden Verfahrens darstellen, so dass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

## Patentansprüche

1. Halbleiterstruktur (100; 200; 300; 500) mit folgenden Merkmalen:

   einer Barriereschicht (110), die AlGaInN, AlInN oder AlGaN aufweist;
   einer Abstandshalterstruktur (120), die eine erste Aluminiumnitridschicht (122), eine Zwischenschicht (124) und eine zweite Aluminiumnitridschicht (126) aufweist, wobei die Zwischenschicht (124) ein Gruppe-III-Nitrid aufweist und zwischen der ersten Aluminiumnitridschicht (122) und der zweiten Aluminiumnitridschicht (126) angeordnet ist, und wobei die Zwischenschicht (124) an einer Grenzfläche zu der zweiten Aluminiumnitridschicht (126) eine erste freie Ladungsträgerdichte aufweist; und
   einer Kanalschicht (130), die ein Gruppe-III-Nitrid aufweist, wobei die Abstandshalterstruktur (120) zwischen der Barriereschicht (110) und der Kanalschicht (130) angeordnet ist,
   wobei die Abstandshalterstruktur auf der Kanalschicht aufgewachsen ist und die AlGaInN-Barriereschicht, die AlInN-Barriereschicht oder die AlGaN-Barriereschicht auf der Abstandshalterstruktur aufgewachsen ist, so dass die Barriereschicht (110) direkt an die zweite Aluminiumnitridschicht (126) und die Kanalschicht (130) direkt an die erste Aluminiumnitridschicht (122) angrenzt,
   und wobei die Kanalschicht (130) an der Grenzfläche zu der ersten Aluminiumnitridschicht (122) der Abstandshalterstruktur (120) eine zweite freie Ladungsträgerdichte aufweist, wobei die erste Aluminiumnitridschicht (122), die Zwischenschicht (124) und die zweite Alumimumnitridschicht (126) Schichtdicken aufweisen, so dass die erste freie Ladungsträgerdichte kleiner als 10 % der zweiten freien Ladungsträgerdichte ist.

2. Halbleiterstruktur gemäß Anspruch 1, wobei die Schichtdicke der Zwischenschicht (124) kleiner ist als die doppelte Schichtdicke der ersten Aluminiumnitridschicht (122) oder wobei die Schichtdicke der Zwischenschicht (124) kleiner ist als das 1,9-fache der Schichtdicke der ersten Aluminiumnitridschicht abzüglich von 0,1 nm.

3. Halbleiterstruktur gemäß Anspruch 1 oder 2, wobei die erste Aluminiumnitridschicht (122) und die zweite Aluminiumnitridschicht (126) Schichtdicken aufweisen, die größer als 0,4 nm und kleiner als 1,4 nm sind, und wobei die Zwischenschicht (124) eine Schichtdicke aufweist, die kleiner als 1,5 nm ist.

4. Halbleiterstruktur gemäß einem der Ansprüche 1 bis 3, wobei die Barriereschicht (110), die Zwischenschicht (124) und die Kanalschicht (130) jeweils ein solches Gruppe-III-Nitride aufweisen, so dass in Kombination mit den Schichtdicken der ersten Aluminiumnitridschicht (122), der zweiten Aluminiumnitridschicht (126) und der Zwischenschicht (124) die erste freie Ladungsträgerdichte kleiner als 10 % der zweiten freien Ladungsträgerdichte ist.

5. Halbleiterstruktur gemäß einem der Ansprüche 1 bis 4, wobei die Zwischenschicht (124) GaN aufweist.

6. Halbleiterstruktur gemäß einem der Ansprüche 1 bis 5, wobei die Kanalschicht GaN oder InGaN aufweist.

7. Halbleiterstruktur gemäß einem der Ansprüche 1 bis 6, wobei die Barriereschicht (110), die erste Aluminiumnitridschicht (122), die Zwischenschicht (124), die zweite Aluminiumnitridschicht (126) und die Kanalschicht (130) ausgelegt sind, so dass das Leitungsband der Halbleiterstruktur in der Kanalschicht (130) ein Energieminimum aufweist.

8. Halbleiterstruktur gemäß einem der Ansprüche 1 bis 7, wobei die Abstandshalterstruktur (120) die erste Aluminiumnitridschicht (122), die zweite Aluminiumnitridschicht (126) und eine Galliumnitridschicht (124) aufweist, wobei die erste Aluminiumnitridschicht (122) eine Schichtdicke zwischen 0,4 nm und 1,4 nm aufweist, wobei die zweite Aluminiumnitridschicht (126) eine Schichtdicke zwischen 0,4 nm und 1,4 nm aufweist, wobei die Galliumnitridschicht (124) eine Schichtdicke kleiner als 1,5 mm aufweist, wobei die Galliumnitridschicht (124) zwischen der ersten Aluminiumnitridschicht (122) und der zweiten Aluminiumnitridschicht (126) angeordnet ist, und wobei die Galliumnitridschicht (124) an einer Grenzfläche zu der zweiten Aluminiumnitridschicht (126) eine erste freie Ladungsträgerdichte aufweist;
wobei die Kanalschicht (130) Galliumnitrid oder InGaN aufweist,
und wobei die Kanalschicht (130) an einer Grenzfläche zu der ersten Aluminiumnitridschicht (122) der Abstandshalterstruktur (120) eine zweite freie Ladungsträgerdichte aufweist, wobei die erste Aluminiumnitridschicht (122), die Galliumnitridschicht (124) und die zweite Aluminiumnitridschicht (126) Schichtdicken aufweisen, so dass die erste freie Ladungsträgerdichte kleiner als 10 % der zweiten freien Ladungsträgerdichte ist

9. Transistor mit folgenden Merkmalen:

einer Halbleiterstruktur gemäß einem der Ansprüche 1 bis 7;
einem Source-Kontakt (302), der mit der Kanalschicht (130) elektrisch verbunden ist;
einem Drain-Kontakt (304), der mit der Kanalschicht (130) elektrisch verbunden ist;
einem Gate-Kontakt (306), der zwischen dem Source-Kontakt (302) und dem Drain-Kontakt (304) angeordnet ist und ausgelegt ist, um eine Stromstärke eines elektrischen Strom zwischen dem Source-Kontakt (302) und dem Drain-Kontakt (304) in der Kanalschicht (130) durch Anlegen eines elektrischen Gate-Potenzials zu steuern.

10. Verfahren (700) zur Herstellung einer Halbleiterstruktur, mit folgende Schritten:

Herstellen (710) einer Kanalschicht, die ein Gruppe-III-Nitrid aufweist;
Herstellen (720) einer ersten Aluminiumnitridschicht auf der Kanalschicht, so dass die Kanalschicht direkt an die erste Aluminiumnitridschicht angrenzt;
Herstellen (730) einer Zwischenschicht auf der ersten Aluminiumnitridschicht, wobei die Zwischenschicht ein Gruppe-III-Nitrid aufweist;
Herstellen (740) einer zweiten Aluminiumnitridschicht auf der Zwischenschicht; und
Herstellen (750) einer Barriereschicht, die ein Gruppe-III-Nitrid aufweist, wobei die AlGaInN-Barriereschicht, die AlInN-Barnereschicht oder die AlGaN-Barriereschicht auf der zweiten Aluminiumnitridschicht aufgewachsen wird, so dass die Barriereschicht direkt an die zweite Aluminiumnitridschicht angrenzt, wobei die Zwischenschicht an einer Grenzfläche zu der zweiten Aluminiumnitridschicht eine erste freie Ladungsträgerdichte aufweist, und wobei die Kanalschicht an einer Grenzfläche zu der ersten Aluminiumnitridschicht eine zweite freie Ladungsträgerdichte aufweist, wobei die erste Aluminiumnitridschicht, die Zwischenschicht und die zweite Aluminiumnitridschicht Schichtdicken aufweisen, so dass die erste freie Ladungsträgerdichte kleiner als 10 % der zweiten freien Ladungsträgerdichte ist.

11. Verfahren gemäß Anspruch 10, wobei die Zwischenschicht (124) und die erste Aluminiumnitridschicht (122) hergestellt werden, so dass die Schichtdicke der Zwischenschicht (124) kleiner ist als die doppelte Schichtdicke der ersten Aluminiumnitridschicht (122) oder so dass die Schichtdicke der Zwischenschicht (124) kleiner ist als das 1,9-fache der Schichtdicke der ersten Aluminiumnitridschicht abzüglich von 0,1 nm.

12. Verfahren gemäß Anspruch 10 oder 11, wobei die Zwischenschicht (124), die erste Aluminiumnitridschicht (122) und die zweite Aluminiumnitridschicht (126) hergestellt werden, so dass die erste Aluminiumnitridschicht (122) und die zweite Aluminiumnitridschicht (126) Schichtdicken aufweisen, die größer als 0,4 nm und kleiner als 1,4 nm sind, und so dass die Zwischenschicht (124) eine Schichtdicke aufweist, die kleiner als 1,5 nm ist.

**Claims**

1. Semiconductor structure (100; 200; 300; 500) comprising:

   a barrier layer (110) comprising AlGaInN, AlInN or AlGaN;
   a spacer structure (120) comprising a first aluminum nitride layer (122), an intermediate layer (124) and a second aluminum nitride layer (126), wherein the intermediate layer (124) comprises a group III nitride and is arranged between the first aluminum nitride layer (122) and the second aluminum nitride layer (126) and wherein the intermediate layer (124) comprises a first free charge carrier density at an interface with the second aluminum nitride layer (126); and
   a channel layer (130) comprising a group III nitride, wherein the spacer structure (120) is arranged between the barrier layer (110) and the channel layer (130),
   wherein the spacer structure is grown on the channel layer, and the AlGaInN barrier layer, the AlInN barrier layer or the AlGaN barrier layer is grown on the spacer structure so that the barrier layer (110) is directly adjacent to the second aluminum nitride layer (126) and that the channel layer (130) is directly adjacent to the first aluminum nitride layer (122),
   and wherein the channel layer (130) comprises a second free charge carrier density at the interface with the first aluminum nitride layer (122) of the spacer structure (120), wherein the first aluminum nitride layer (122), the intermediate layer (124) and the second aluminum nitride layer (126) comprise layer thicknesses such that the first free charge carrier density is less than 10% of the second free charge carrier density.

2. Semiconductor structure according to claim 1, wherein the layer thickness of the intermediate layer (124) is less than two times the layer thickness of the first aluminum nitride layer (122) or wherein the layer thickness of the intermediate layer (124) is less than 1.9 times the layer thickness of the first aluminum nitride layer minus 0.1 nm.

3. Semiconductor structure according to claim 1 or 2, wherein the first aluminum nitride layer (122) and the second aluminum nitride layer (126) comprise layer thicknesses greater than 0.4 nm and less than 1.4 nm and wherein the intermediate layer (124) comprises a layer thickness of less than 1.5 nm.

4. Semiconductor structure according to any one of claims 1 to 3, wherein the barrier layer (110), the intermediate layer (124) and the channel layer (130) each comprise such a group III nitride so that in combination with the layer thicknesses of the first aluminum nitride layer (122), the second aluminum nitride layer (126) and the intermediate layer (124), the first free charge carrier density is less than 10% of the second free charge carrier density.

5. Semiconductor structure according to any one of claims 1 to 4, wherein the intermediate layer (124) comprises GaN.

6. Semiconductor structure according to any one of claims 1 to 5, wherein the channel layer comprises GaN or InGaN.

7. Semiconductor structure according to any one of claims 1 to 6, wherein the barrier layer (110), the first aluminum nitride layer (122), the intermediate layer (124), the second aluminum nitride layer (126) and the channel layer (130) are designed so that the conduction band of the semiconductor structure in the channel layer (130) comprises an energy minimum.

8. Semiconductor structure according to any one of claims 1 to 7, wherein the spacer structure (120) comprises the first aluminum nitride layer (122), the second aluminum nitride layer (126) and a gallium nitride layer (124), wherein the first aluminum nitride layer (122) comprises a layer thickness between 0.4 nm and 1.4 nm, wherein the second aluminum nitride layer (126) comprises a layer thickness between 0.4 nm and 1.4 nm, wherein the gallium nitride layer (124) comprises a layer thickness of less than 1.5 nm, wherein the gallium nitride layer (124) is arranged between the first aluminum nitride layer (122) and the second aluminum nitride layer (126) and wherein the gallium nitride layer (124) comprises a first free charge carrier density at an interface with the second aluminum nitride layer (126);

wherein the channel layer (130) comprises gallium nitride or InGaN,

and wherein the channel layer (130) comprises a second free charge carrier density at an interface with the first aluminum nitride layer (122) of the spacer structure (120), wherein the first aluminum nitride layer (122), the gallium nitride layer (124) and the second aluminum nitride layer (126) comprise layer thicknesses such that the first free charge carrier density is less than 10% of the second free charge carrier density.

9. Transistor comprising:

a semiconductor structure according to any one of claims 1 to 7;
a source contact (302) which is electrically connected to the channel layer (130);
a drain contact (304) which is electrically connected to the channel layer (130);
a gate contact (306) which is arranged between the source contact (302) and the drain contact (304) and is designed to control an amperage of an electric current between the source contact (302) and the drain contact (304) in the channel layer (130) by applying an electric gate potential.

10. Method (700) for producing a semiconductor structure, comprising:

producing (710) a channel layer comprising a group III nitride;
producing (720) a first aluminum nitride layer on the channel layer so that the channel layer is directly adjacent to the first aluminum nitride layer,
producing (730) an intermediate layer on the first aluminum nitride layer, wherein the intermediate layer comprises a group III nitride;
producing (740) a second aluminum nitride layer on the intermediate layer; and
producing (750) a barrier layer comprising a group III nitride, wherein the AlGaInN barrier layer, the AlInN barrier layer or the AlGaN barrier layer is grown on the second aluminum nitride layer so that the channel layer is directly adjacent to the second aluminum nitride layer, wherein the intermediate layer comprises a first free charge carrier density at an interface with the second aluminum nitride layer and wherein the channel layer comprises a second free charge carrier density at an interface with the first aluminum nitride layer, wherein the first aluminum nitride layer, the intermediate layer and the second aluminum nitride layer comprise layer thicknesses such that the first free charge carrier density is less than 10% of the second free charge carrier density.

11. Method according to claim 10 wherein the intermediate layer (124) and the first aluminum nitride layer (122) are produced so that the layer thickness of the intermediate layer (124) is less than two times the layer thickness of the first aluminum nitride layer (122) or so that the layer thickness of the intermediate layer (124) is less than 1.9 times the layer thickness of the first aluminum nitride layer minus 0.1 nm.

12. Method according to claim 10 or 11 wherein the intermediate layer (124), the first aluminum nitride layer (122) and the second aluminum nitride layer (126) are produced so that the first aluminum nitride layer (122) and the second aluminum nitride layer (126) comprise layer thicknesses greater than 0.4 nm and less than 1.4 nm so that the intermediate layer (124) comprises a layer thickness of less than 1.5 nm.

## Revendications

1. Structure semi-conductrice (100; 200; 300; 500), aux caractéristiques suivantes:

une couche barrière (110) présentant de l'AlGaInN, de l'AlInN ou de l'AlGaN;
une structure d'écartement (120) présentant une première couche de nitrure d'aluminium (122), une couche intermédiaire (124) et une deuxième couche de nitrure d'aluminium (126), la couche intermédiaire (124) présentant un nitrure du groupe III et étant disposée entre la première couche de nitrure d'aluminium (122) et la deuxième couche de nitrure d'aluminium (126), et la couche intermédiaire (124) présentant, à une interface avec la deuxième couche de nitrure d'aluminium (126), une première densité de porteurs de charge libres; et une couche de canal (130) présentant un nitrure du groupe III, la structure d'écartement (120) étant disposée entre la couche barrière (110) et la couche de canal (130),

dans laquelle la structure d'écartement est cultivée sur la couche de canal et la couche barrière d'AlGaInN, la couche barrière d'AlInN ou la couche barrière d'AlGaN est cultivée sur la structure d'écartement, de sorte que la couche barrière (110) soit directement adjacente à la deuxième couche de nitrure d'aluminium (126) et que la couche de canal (130) soit directement adjacente à la première couche de nitrure d'aluminium (122),

et dans laquelle la couche de canal (130) présente, à l'interface avec la première couche de nitrure d'aluminium (122) de la structure d'écartement (120), une deuxième densité de porteurs de charges libres, la première couche de nitrure d'aluminium (122), la couche intermédiaire (124) et la deuxième couche de nitrure d'aluminium (126) présentant des épaisseurs de couche de sorte que la première densité de porteurs de charges libres soit inférieure à 10% de la deuxième densité de porteurs de charges libres.

2.  Structure semi-conductrice selon la revendication 1, dans laquelle l'épaisseur de la couche intermédiaire (124) est inférieure à deux fois l'épaisseur de la première couche de nitrure d'aluminium (122) ou dans laquelle l'épaisseur de la couche intermédiaire (124) est inférieure à 1,9 fois l'épaisseur de la première couche de nitrure d'aluminium moins 0,1 nm.

3.  Structure semi-conductrice selon la revendication 1 ou 2, dans laquelle la première couche de nitrure d'aluminium (122) et la deuxième couche de nitrure d'aluminium (126) présentent des épaisseurs de couche qui sont supérieures à 0,4 nm et inférieures à 1,4 nm, et dans laquelle la couche intermédiaire (124) présente une épaisseur de couche qui est inférieure à 1,5 nm.

4.  Structure semi-conductrice selon l'une des revendications 1 à 3, dans laquelle la couche barrière (110), la couche intermédiaire (124) et la couche de canal (130) présentent, chacune, un tel nitrure du groupe III, de sorte que, en combinaison avec les épaisseurs de couche de la première couche de nitrure d'aluminium (122), de la deuxième couche de nitrure d'aluminium (126) et de la couche intermédiaire (124), la première densité de porteurs de charges libres soit inférieure à 10% de la deuxième densité de porteurs de charges libres.

5.  Structure semi-conductrice selon l'une des revendications 1 à 4, dans laquelle la couche intermédiaire (124) présente du GaN.

6.  Structure semi-conductrice selon l'une des revendications 1 à 5, dans laquelle la couche de canal présente du GaN ou de l'InGaN.

7.  Structure semi-conductrice selon l'une des revendications 1 à 6, dans laquelle la couche barrière (110), la première couche de nitrure d'aluminium (122), la couche intermédiaire (124), la deuxième couche de nitrure d'aluminium (126) et la couche de canal (130) sont conçues de sorte que la bande de conduction la structure semi-conductrice présente un minimum d'énergie dans la couche de canal (130).

8.  Structure semi-conductrice selon l'une des revendications 1 à 7, dans laquelle la structure d'écartement (120) présente la première couche de nitrure d'aluminium (122), la deuxième couche de nitrure d'aluminium (126) et une couche de nitrure de gallium (124), dans laquelle la première couche de nitrure d'aluminium (122) présente une épaisseur de couche comprise entre 0,4 nm et 1,4 nm, dans laquelle la deuxième couche de nitrure d'aluminium (126) présente une épaisseur de couche comprise entre 0,4 nm et 1,4 nm, dans laquelle la couche de nitrure de gallium (124) présente une épaisseur de couche inférieure à 1,5 nm, dans laquelle la couche de nitrure de gallium (124) est disposée entre la première couche de nitrure d'aluminium (122) et la deuxième couche de nitrure d'aluminium (126), et dans laquelle la couche de nitrure de gallium (124) présente une première densité de porteurs de charges libres à une interface avec la deuxième couche de nitrure d'aluminium (126);

dans laquelle la couche de canal (130) présente du nitrure de gallium ou de l'InGaN, et dans laquelle la couche de canal (130) présente, à une interface avec la première couche de nitrure d'aluminium (122) de la structure d'écartement (120), une deuxième densité de porteurs de charges libres, la première couche de nitrure d'aluminium (122), la couche de nitrure de gallium (124) et la deuxième couche de nitrure d'aluminium (126) présentant des épaisseurs de couche de sorte que la première densité de porteurs de charges libres soit inférieure à 10% de la deuxième densité de porteurs de charges libres.

9.  Transistor aux caractéristiques suivantes:

une structure semi-conductrice selon l'une des revendications 1 à 7;
un contact de source (302) qui est relié électriquement à la couche de canal (130);
un contact de drain (304) qui est relié électriquement à la couche de canal (130);
un contact de porte (306) qui est disposé entre le contact de source (302) et le contact de drain (304) et est conçu pour réguler une intensité d'un courant électrique entre le contact de source (302) et le contact de drain (304) dans la couche de canal (130) par application d'un potentiel de porte électrique.

10. Procédé (700) pour fabriquer une structure semi-conductrice, aux étapes suivantes consistant à:

réaliser (710) une couche de canal qui présente un nitrure du groupe III;
réaliser (720) une première couche de nitrure d'aluminium sur la couche de canal, de sorte que la couche de canal soit directement adjacente à la première couche de nitrure d'aluminium;
réaliser (730) une couche intermédiaire sur la première couche de nitrure d'aluminium, la couche intermédiaire présentant un nitrure du groupe III;
réaliser (740) une deuxième couche de nitrure d'aluminium sur la couche intermédiaire; et
réaliser (750) une couche barrière présentant un nitrure du groupe III, la couche barrière d'AlGaInN, la couche de barrière d'AlInN ou la couche barrière d'AlGaN étant cultivée sur la deuxième couche de nitrure d'aluminium, de sorte que la couche barrière soit directement adjacente à la deuxième couche de nitrure d'aluminium, la couche intermédiaire présentant une première densité de porteurs de charges libres à une interface avec la deuxième couche de nitrure d'aluminium, et la couche de canal présentant une deuxième densité de porteurs de charges libres à une interface avec la première couche de nitrure d'aluminium, la première couche de nitrure d'aluminium, la couche intermédiaire et la deuxième couche de nitrure d'aluminium présentant une épaisseur de sorte que la première densité de porteurs de charges libres soit inférieure à 10% de la deuxième densité de porteurs de charges libres.

11. Procédé selon la revendication 10, dans lequel la couche intermédiaire (124) et la première couche de nitrure d'aluminium (122) sont réalisées de sorte que l'épaisseur de la couche intermédiaire (124) soit inférieure à deux fois l'épaisseur de la première couche de nitrure d'aluminium (122) ou que l'épaisseur de la couche intermédiaire (124) soit inférieure à 1,9 fois l'épaisseur de la première couche de nitrure d'aluminium moins 0,1 nm.

12. Procédé selon la revendication 10 ou 11, dans lequel la couche intermédiaire (124), la première couche de nitrure d'aluminium (122) et la deuxième couche de nitrure d'aluminium (126) sont réalisées de sorte que la première couche de nitrure d'aluminium (122) et la deuxième couche de nitrure d'aluminium (126) présentent des épaisseurs de couche supérieures à 0,4 nm et inférieures à 1,4 nm, et de sorte que la couche intermédiaire (124) présente une épaisseur de couche qui est inférieure à 1,5 nm.

100

**FIGUR 1**

200

**FIGUR 2**

**FIGUR 3**

EP 2 465 142 B1

FIGUR 4

EP 2 465 142 B1

**FIGUR 5**

FIGUR 6

700

Herstellen einer Kanalschicht,
die ein Gruppe-III-Nitrid aufweist. — 710

Herstellen einer ersten Aluminiumnitridschicht auf der Kanalschicht. — 720

Herstellen einer Zwischenschicht
auf der ersten Aluminiumnitridschicht,
wobei die Zwischenschicht
ein Gruppe-III-Nitrid aufweist. — 730

Herstellen einer zweiten Alumiumnitridschicht auf der Zwischenschicht. — 740

Herstellen einer Barriereschicht, die ein Gruppe-III-Nitrid
aufweist, wobei die Zwischenschicht an einer Grenzfläche
zu der zweiten Aluminiumnitridschicht eine erste freie
Ladungsträgerdichte aufweist, und wobei die Kanalschicht
an einer Grenzfläche zu der ersten Aluminiumnitridschicht
eine zweite freie Ladungsträgerdichte aufweist, wobei die
erste Aluminiumnitridschicht, die Zwischenschicht und die
zweite Aluminiumnitridschicht Schichtdicken aufweisen,
so dass die erste freie Ladungsträgerdichte kleiner als
10% der zweiten freien Ladungsträgerdichte ist. — 750

# FIGUR 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20020058349 A1
- US 20080054303 A1
- US 20060197109 A1
- JP 2003257999 A

**In der Beschreibung aufgeführte Nicht-Patentliteratur**

- **GONSCHOREK et al.** *Appl. Phys. Lett.,* 2006, vol. 89, 062106
- **XIE et al.** *Appl. Phys. Lett.,* 2007, vol. 91, 132116
- **LIU et al.** *Appl. Phy. Lett.,* 2005, vol. 86, 223510
- **LIU et al.** *Jpn. J. Appl. Phys.,* 2006, vol. 45, 5728-5731
- **ADIVARAHAN et al.** *IEEE Trans. Electron Devices,* 2008, vol. 55, 495-499
- **MATSUOKA.** *Appl. Phys. Lett.,* 1997, vol. 71, 105-106
- **LU et al.** *IEEE Trans. Electron Devices,* 2003, vol. 50, 1069-1074